# EUROPEAN PATENT APPLICATION

(11) **EP 1 433 740 A1**
(43) Date of publication of application: **30.06.2004**
(21) Application number: 02447270.6
(22) Date of filing: 24.12.2002
(51) Int. Cl.: B81B 7/00

(54) **Method for the closure of openings in a film**

(71) Applicant: INTERUNIVERSITAIR MICROELEKTRONICA CENTRUM VZW, 3001 Leuven (BE)
(72) Inventor: Witvrouw, Ann, 3020 Herent (BE); Rusu, Cristina, 43169 Mölndal (SE)
(74) Representative: Bird, William Edward

(57) **Abstract**

A method is described for closing openings in a film, for example, in microelectronic process technology, whereby substantially no deposition material passes through the openings, which can be important if fragile microdevices are positioned under the openings. The closure of these openings can cause an underlying cavity to be hermetically sealed, in which an object can be located. In particular the method provides a way for hermetically sealing cavities under controlled atmosphere and pressure in the encapsulation and sealing processes of cavities containing fragile content. The cavities can contain for instance Micro Electro Mechanical Systems (MEMS). The method can be used for encapsulating devices which may require a controlled atmosphere and pressure encapsulation such as micro accelerometers, micro gyroscopes, micro tubes, vibration micro sensors, micro mirrors, micro mechanical resonators or "resonant strain gauges", micro mechanical filters, micro switches, micro electrical circuits, micro relays, Integrated Circuits with airgaps etc.

## Description

### FIELD OF THE INVENTION

The present invention is related to microelectronic process technology. In particular it relates to Micro- and Nano-Electro Mechanical Systems (MEMS and NEMS) process technology. The present invention relates to a method for the closure of openings in a horizontal film whereby substantially no sealing material passes through the openings. The closure of these openings can cause an underlying cavity to be hermetically sealed, in which an object can be located. This sealing can be performed at controllable atmosphere and pressure. It also relates to the encapsulation process of MEMS and NEMS.

### BACKGROUND OF THE INVENTION

Many micro-electromechanical systems (MEMS) require an encapsulation under vacuum or under a controlled atmosphere and pressure in order to ensure either a good performance or an acceptable lifetime of operation. The encapsulation has to be performed without the deposition of sealing material on the MEMS device, which can cause damage to the device. In [H.A.T. Tilmans, M.D.J.van de Peer, E. Beyne, "The indent reflow sealing (IRS) technique-a method for fabrication of sealed cavities for MEMS devices", *J.MEMS,* **9**, p.206-217, 2000.] two approaches for wafer-scale zero-level packaging are mentioned.

The most popular approach is based on wafer bonding. Here the sealing is performed by connecting two wafers (device wafer and capping wafer) together by means of a reflowable material. An example of such packaging is described in patent EP-A-0951069. In this approach an expensive substrate, e.g. a Si wafer or a MEMS substrate, is used as a cap to close the cavity comprising the MEMS device. These wafers are thick and the sealing ring is large. Therefore, the resulting encapsulated MEMS device is space consuming. Batch processing is moreover not possible.

Alternatively, encapsulation can be done by the fabrication and sealing of surface micro machined membranes. The use of conformal LPCVD films [C. Liu, Y.C. Tai, Sealing of micro machined cavities using chemical vapor deposition methods: characterisation and optimization, *J.MEMS,* **8**, p.135-145, 1999.] is a known method for encapsulation at low pressure. The sealing of the cavity comprising the MEMS devices is done while depositing the conformal film. Hence, the atmosphere and pressure of the sealed MEMS device are those of the deposition chamber. Methods for sealing at higher pressures up to the order of atmospheric pressure and a few times that value, by the deposition of thin films, are however not widespread. Moreover most of these atmospheric pressure techniques do not prevent material deposition inside the cavity.

MEMS devices can be very fragile and deposition of material on the device should be avoided. As disclosed in "Silicon processing for the VLSI era, vol. 1 - Process Technology", 2^{nd} ed., 2000, S. Wolf and R. N. Tauber, chapter 11.8, pages 475-7, hole filling may be performed by sputtering, e.g. in the formation of a via. This technique is not suitable for sealing cavities in which fragile devices are located, i.e. in cases in which the fragile device would be buried in the filling substance.

### AIM OF THE INVENTION

An aim of the present invention is to provide a method of sealing a opening, e.g. in a film above a cavity in a semiconductor cavity, which allows a greater freedom as to the atmosphere used during the sealing encapsulation. Preferably the sealing takes up less space. The encapsulation should preferably not involve expensive processes or materials. Preferably the process should allow hermetic sealing of an opening.

### SUMMARY OF THE INVENTION

The invention provides a method for closing openings in a film, for example, in microelectronic process technology, whereby substantially no deposition material passes through the openings, which can be important if fragile microdevices are positioned under the openings. The closure of these openings can cause an underlying cavity to be hermetically sealed, in which an object can be located. In particular the method provides a way for hermetically sealing cavities under controlled atmosphere and pressure in the encapsulation and sealing processes of cavities containing fragile content. The cavities can contain for instance Micro Electro Mechanical Systems (MEMS). The method can be used for encapsulating devices which may require a controlled atmosphere and pressure encapsulation such as micro accelerometers, micro gyroscopes, micro tubes, vibration micro sensors, micro mirrors, micro mechanical resonators or "resonant strain gauges", micro mechanical filters, micro switches, micro electrical circuits, micro relays, Integrated Circuits with airgaps etc.

In accordance with the invention method comprises closing an opening (4) in a film (3) with a reflow material, the method comprising: depositing a reflow layer (7) on said film (3) under a first set of pressure and atmosphere conditions to partially close the opening (4), and reflowing said reflow layer (7) under a second set of pressure and atmosphere conditions to close the opening (4) by the reflow layer covering over the opening (4). The reflowing step is preferably carried out at a temperature below 1000°C. The method in accordance with the present invention can be executed in such a way that it does not allow substantially any amount of reflow material to pass through the opening (4).

The present invention will now be described with reference to the following drawings.

### SHORT DESCRIPTION OF FIGURES

Fig. 1 shows the notion of a span of an opening.
Fig.2 shows the notion of a span for a circular and rectangular opening.
Fig 3 shows a structure onto which the invention can be applied, namely a cavity, containing a fragile device e.g. a MEMS device, to be sealed off by closing the openings or trenches in the film that is covering it.
Fig. 5 shows a first embodiment of the present invention.

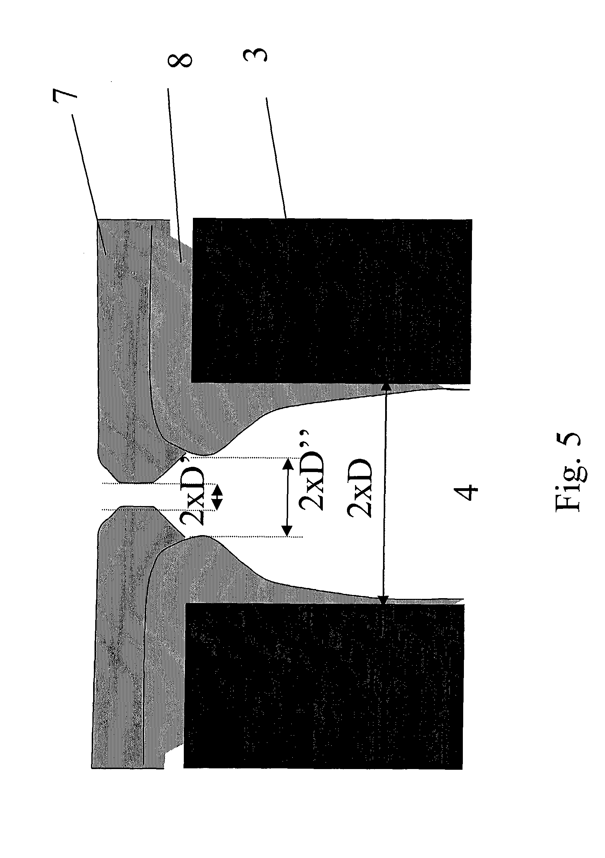

Fig. 5 shows a second embodiment of the present invention.

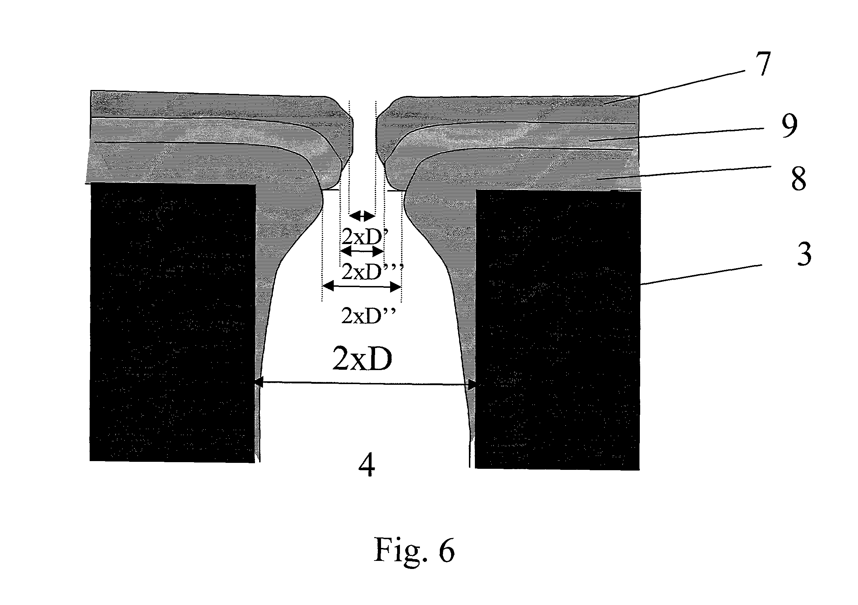

Fig. 6 shows a third embodiment of the present invention.

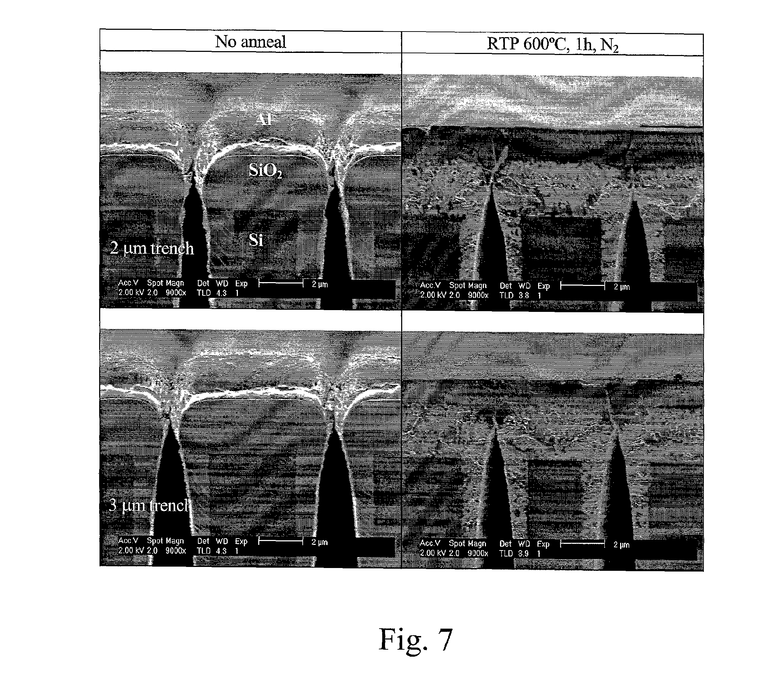

Fig. 7 shows experimental results according to the second embodiment of the invention: 1.5 m evaporated Al on 2.2 m PECVD SiO₂ on Si trenches before and after reflow.

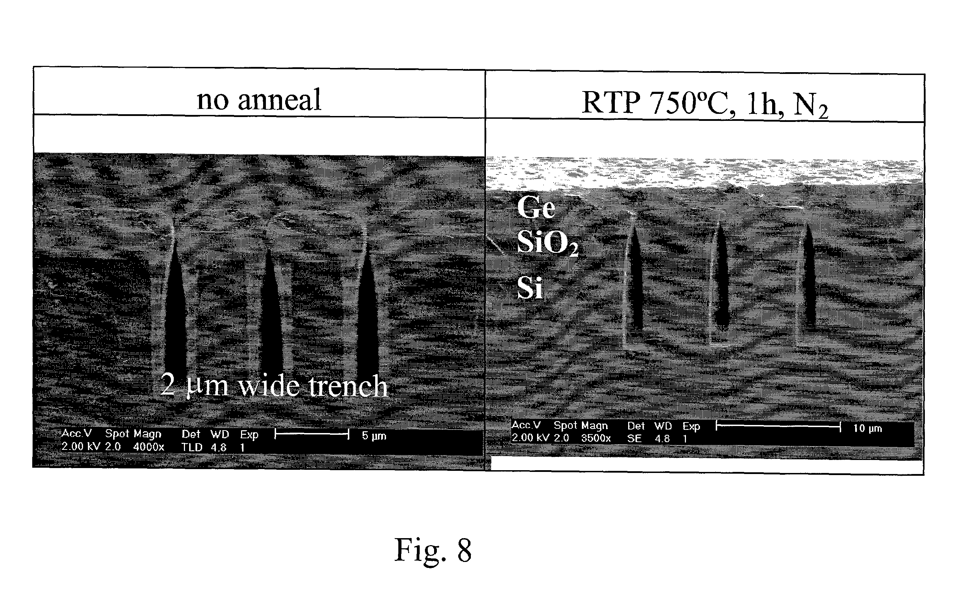

Fig. 8 shows experimental results according to the second embodiment of the invention: 2 m PECVD Ge, 50 W, on 2.2 m SiO₂ on Si trenches before and after reflow.

### DETAILED DESCRIPTION

The following description and examples illustrate preferred embodiments of the present invention in detail. Those of skill in the art will recognise that there are numerous variations and modifications of this invention that are encompassed by its scope. Accordingly, the description of preferred embodiments should not be deemed to limit the scope of the present invention.

For the purpose of this invention the notion of 'a controlled atmosphere' stands for controlled constitution of ambient gas. The notion of 'horizontal' is defined as substantially orthogonal to the direction of the gravitational field.

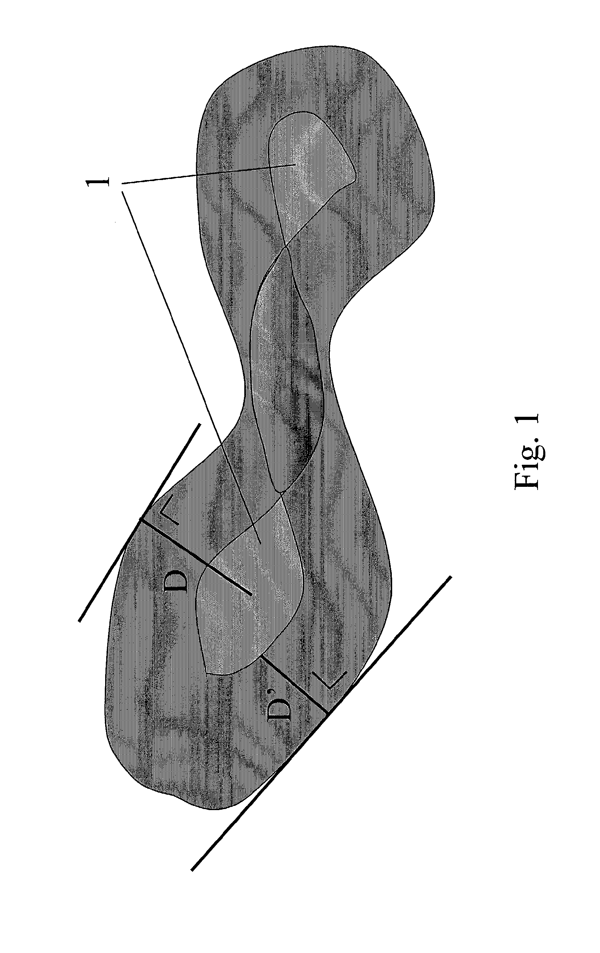

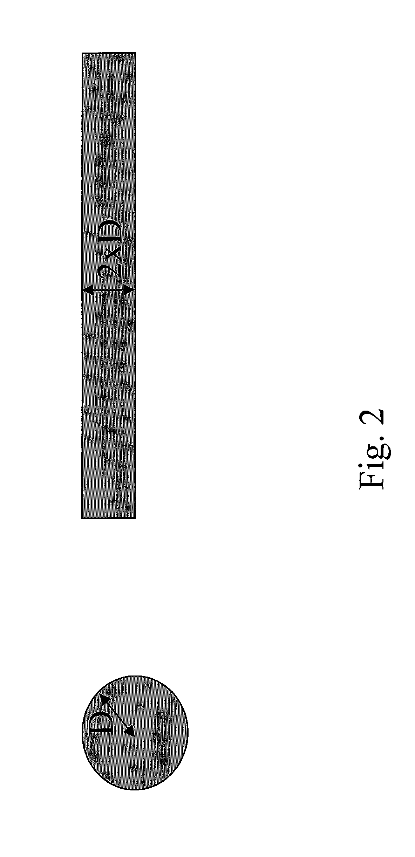

A method for closing an opening in a film is disclosed, wherein essentially no closing material passes through the opening. For the purpose of this invention, the notion of 'essentially no material passing through the openings' should be understood as 'no or only a limited amount of material passing in and/or through the openings'. In the context of sealing of a cavity that contains a fragile device it should be such that the proper working of the device is not affected by the limited amount of material that passes. The openings can be holes or trenches of different shapes. For the purpose of this invention, an indicative measure for the dimensions of the opening is given by the parameter called 'span' (D) which is defined as the minumum value of the distance, measured orthogonally to the contour of the opening, for which the coverage along the whole contour of the opening causes the complete opening to be closed. This is illustrated in Fig. 1. For a distance D' smaller then D the areas defined by (1) remain uncovered. For a distance equal or larger then D the whole opening will be covered. For instance for a circular opening, D corresponds to the radius and for a rectangular opening, D corresponds to half of the width. This is illustrated in Fig. 2.

The present invention can preferably be used for openings with a span D between 0.25 *µm* and 5 *µm* , but larger openings are not excluded. More preferably the method can be used for openings with a span D between 1 *µm* and 2.5 *µm* .

Preferably the method can be used in the field of sealing techniques for wafer-scale zero-level packaging by thin film caps, for which it brings the additional advantage of hermetically sealing at a controlled atmosphere and pressure.

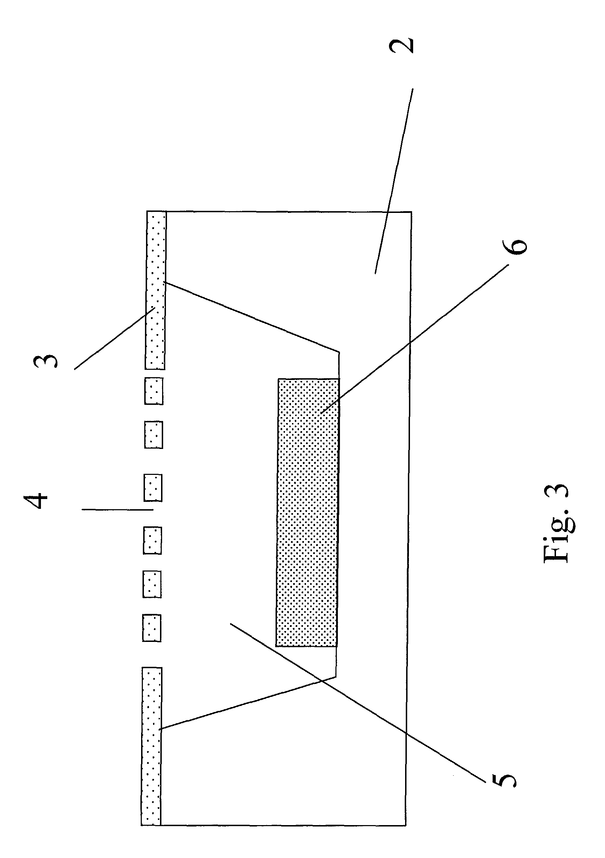

A generic illustration of a device (6) on which the method could be applied is shown in Fig. 3. The substrate (2) and the membrane layer (3) of Fig. 3 can be any substrate and membrane layer used in MEMS processing. Examples of substrates are single crystal or polycrystalline Si, single crystal or poly-crystalline Ge, glass, quartz, polymer, etc. and examples of membranes are polycrystalline SiGe, metal films, oxide-based or nitride-based films, polymer, single crystal or polycrystalline Si, etc. The membrane (3) can be conducting, isolating, semiconducting, etc. The fragile device (6) can be any MEMS device requiring a vacuum or controlled atmosphere and pressure encapsulation. Examples are micro-accelerometers, micro-gyroscopes, micro-tubes, vibration micro-sensors, micro-mirrors, micro-mechanical resonators or "resonant strain gauges", micro-mechanical filters, micro-switches, micro-electrical circuits, micro-relays, Integrated Circuits with airgaps etc.

The atmosphere and pressure of the cavity (5) can be controlled by sealing the openings (4) in the membrane (3).

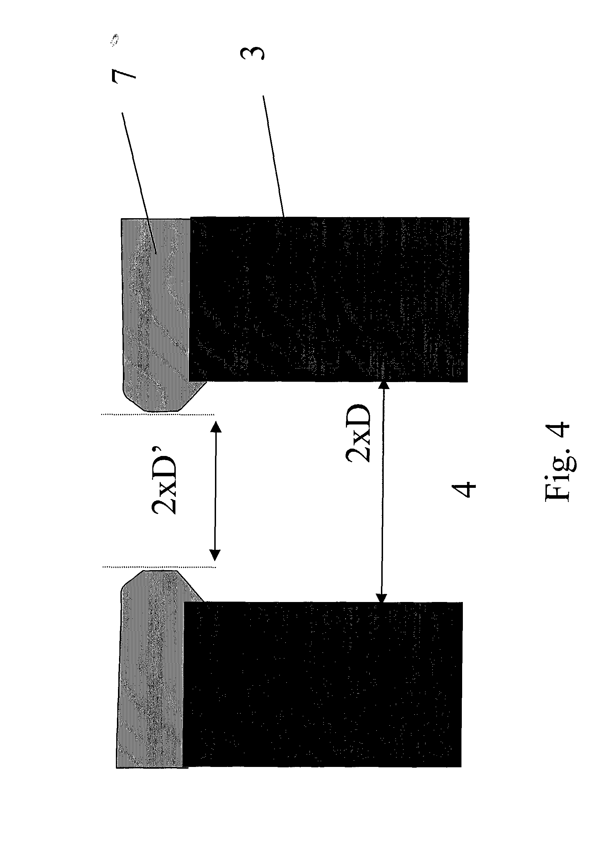

In a first embodiment of the present invention (Fig. 4) a low melting temperature material (sealing layer or reflow layer (7)) is deposited on top of the film (3) containing openings (4) until they are almost completely sealed. This layer is preferably thin enough such that the closing of the cavity does not occur. The original openings with a span D can be reduced to openings with a span D', where D'<D. D can be of the order of 0.25-*1 µm* D' can be of the order of 0.05-0.25 *µm*.The deposition is performed under optimal conditions for deposition. This may include optimal in the sense of avoiding deposition material to pass through the openings. This material is then reflowed in a furnace with controlled atmosphere and pressure such that the final openings are closed, which in case of sealing, causes the underlying cavity to obtain the atmosphere and pressure used for the reflow process. The reflow process doesn't cause essentially any amount of material to enter the openings. The reflow layer can act as a functional layer of the device or of other devices.

In another aspect, the present invention can provide a decoupling of the process of closing openings in a membrane and the process of sealing cavities under predetermined atmosphere and pressure. For instance, if a material would be deposited until the openings are closed in a one step process and a controlled atmosphere and pressure would be required in the to be sealed cavity, the deposition conditions have to correspond with the required atmosphere and pressure in the cavity after sealing. This limits the choice of deposition techniques, or limits the scope of possible atmospheres and pressures that may be required within the cavity. Especially, the amount of deposition material that is able to penetrate the openings depends strongly upon the deposition conditions.

In a second embodiment of the present invention (Fig.5) the method comprises the creation of an intermediate layer (8), which prevents reaction between sealing and membrane layer, which is stable during reflow and which narrows down the opening to be sealed.

In the opening, a first layer (8) is deposited. This first layer can be preferrably a dielectric layer, e.g. a nitride layer, an oxide layer, and can for instance be deposited using known CVD methods, which have a low step-coverage. This first layer (8) can insulate the later deposited sealing layer (7), which can be conductive, from the membrane (3). This first layer (8) can also promote the adhesion of the sealing layer or reflow layer (7) formed on this first layer.

After the first layer (8) a second layer (reflow layer or sealing layer) (7) can be deposited. Any material that can be deposited and which can be reflowed at a temperature below the critical temperature of the whole device, can be used. Deposition techniques can be for instance Physical or Chemical Vapor Deposition or evaporation. Examples are: metals such as Ti, Ta, W, Al, Cu, Cr etc., alloys, eutectic alloys, semiconductor materials such as Ge etc., solder materials such as SnPb, In, Bi, etc.

The final sealing can be done by a reflow step in a furnace in which the pressure and/or atmosphere can be controlled. The reflow temperature is normally a temperature somewhat (e.g. 30 to 100°C) below the bulk melting point of the material of (7). Hence, materials should be selected such that the reflow temperature is, preferably below the melting and evaporation temperatures of all the materials used or in other words below the critical temperature of the whole of device and package. The reflow temperature should thus also be below the critical temperature of the substrate (2) comprising the fragile devices (6), e.g. MEMS device and below the critical temperature of this fragile device. The viscosity of the second material (7) must be high enough such that the overlap or encroachment of the opening (corresponding to D") is at least maintained and that this material (7) doesn't slide down along the side walls of the opening (corresponding to D"). Preferably D'<D".

An aspect of the present invention can be planarazation after reflow, so that after the reflow of the second layer a substantially flat surface can be achieved, which can be an advantage for further processing on top of the embedded device.

In a further embodiment of the present invention another intermediate layer (9) can be formed between the first layer (7) and the second layer (8) as shown in Fig 6. The material of this intermediate layer (9) can then be chosen such that it is a good wetting layer for the reflow of the reflow layer (7). For example, Ti may be used as an intermediate layer and Al as reflow layer. In this embodiment it is also the reflow layer (7) that will close the opening (4, the part corresponding to D') during the reflow. A wetting layer, e.g. Ti or Ti-silicide as wetting layer for Al reflow (see for example [Influence of Ti, TiN, and TiSi_{2,4} underlayers on Al-Si-Cu reflow sputtering, Proceeding of *VLSI multilevel interconnection conference,* 7-8 June, Santa Clara, USA, p. 336-342, 1994.]) can lower the reflow temperature. Thus, without the presence of an intermediate layer 9, if the first layer material of (8) is a good wetting layer for the reflow of the sealing layer (7), reflow temperatures can be lowered. The intermediate layer (9) can assist in closing the opening in that during formation of this intermediate layer (9) the opening is already narrowed (D'''<D''), an effect commonly known in deposition of materials into openings and where normally measures are taken to avoid the problem of formation of such collar on the top of the opening. Here this narrowing effect is exploited such that when the reflow layer (7) is deposited already smaller openings (D'''< D") are present. The thus formed collar will again prevent the gliding down of the material of the reflow layer (7) along the sides of the opening (4), but will result in the piling up of the reflow material within the spacing (corresponding to D''') of the remaining openings between the intermediate layer (9).

The 'reflow' at higher pressure, as e.g. atmospheric pressure depends on the 'native oxide' film that is on the metal (7). A 'protection layer', e.g. Au, can prevent the formation of the 'native oxide'.

The atmosphere and the pressure inside the furnace determine the final pressure and atmosphere inside the cavity. Possible atmospheres are, for example, inert gasses such as He or Ar, nitrogen or other gasses such as oxygen. The pressure can preferably be any pressure between vacuum pressure (e.g. 10E-6 mbar) and a few times atmospheric pressure. More preferably it can be a pressure between vacuum pressure and 2 atm. Even more preferably it can be a pressure between vacuum pressure and 1.2 atm.

A specific embodiment of the present invention is depicted in Fig. 7. The reflow material was a metal, Al, which can be used as an electrical contact layer besides sealing the trenches. An intermediate layer of PECVD SiO₂ between Si and Al was deposited. The reflow was performed at 600°C for 1 hour in a N₂ atmosphere at atmospheric pressure, closing the trenches as can be seen in Fig. 7. Substantially no material entered the trenches.

Another specific embodiment of the present invention is shown in Fig.8. Here PECVD Ge was deposited on an intermediate layer of Si0₂. The Ge deposition was performed at an RF power of 50 W and the reflow at 750°C for 1 hour in a N₂ atmosphere at atmospheric pressure. Different Ge thickness and annealing conditions are possible. In Fig. 8 it is shown that 2 *µm* wide trenches were closed by Ge. After reflow the surface was flattened.

## Claims

1. A method for closing an opening (4) in a film (3) with a reflow material, the method comprising:
depositing a reflow layer (7) on said film (3) under a first set of pressure and
atmosphere conditions to partially close the opening (4), and
reflowing said reflow layer (7) under a second set of pressure and atmosphere conditions to close the opening (4) by the reflow layer covering over the opening (4).

2. The method according to claim 1, further comprising:
depositing a first layer (8) on said film (3) before depositing said reflow layer (7).

3. The method according to claim 1 to 2, further comprising:
depositing a wetting layer (9) on said first layer (8) before depositing said reflow layer (7).

4. The method according to any of claims 1 to 3 in which said opening (4) has a span within the range of 0.25 m and 5 m , or within the range of 1 m and 2.5 m.

5. The method according to any of the claims 1 to 4, in which said opening (4) in the film (3) is an opening above an underlying cavity (5) in a substrate (2).

6. The method according to any of claims 2 to 5 in which said first layer (8) is a dielectric layer.

7. The method according to any of claims 2 to 6, in which said first layer (8) is formed by a chemical vapour deposition technique with a low step coverage.

8. The method according to any of claims 1 to 7 wherein said reflow layer (7) is a layer deposited by an evaporation technique or a chemical or physical vapour deposition technique.

9. The method according to any of claims 1 to 8, wherein said reflow layer (7) is a conductive layer.

10. The method according to any of claims 1 to 9, wherein said reflow layer (7) is planarized during or after reflow.

11. The method according to any of the claims 5 to 10, in which the cavity (5) is part of a Micro- or Nano-Electro-Mechanical System (6).

12. The method according to any of the claims 5 to 11, wherein reflow is performed at a temperature lower than at least one of the following: the melting temperature of the substrate (2), the melting temperature of said film (3), the melting temperature of said first layer (8), the melting temperature of said wetting layer (9), and the critical temperature of the device (6) inside the cavity (5).

13. The method according to any of claims 5 to 12, wherein the cavity (5) is sealed under controlled atmosphere and pressure by reflowing said reflow layer (7) under said second set of atmosphere and pressure conditions.

14. The method according to any of claims 1 to 13, wherein the pressure during the reflow process is essentially atmospheric pressure.

15. The method according to any of claims 5 to 14, wherein the cavity (5) contains a fragile device (6) on which substantially no material may be deposited during the closure process to guarantee the proper working and lifetime of the device (6).

16. The method according to any of claims 1 to 15 wherein there are more than one opening (4) and each opening belongs to a different cavity (5), wherein the openings are closed simultaneously.

17. The method according to any of claims 1 to 16, used in a batch process.
